# EUROPEAN PATENT SPECIFICATION

(11) **EP 4 333 564 B1**
(45) Date of publication and mention of the grant of the patent: **24.12.2025**
(21) Application number: 22795770.1
(22) Date of filing: 26.04.2022
(51) Int. Cl.: H05H 1/46, C23C 14/34, C23C 14/35, H01J 37/34, H01J 37/32

(54) **SPUTTERING APPARATUS**
SPUTTERVORRICHTUNG
APPAREIL DE PULVÉRISATION

(30) Priority: 30.04.2021 JP 2021077125
(43) Date of publication of application: 06.03.2024
(73) Proprietor: EMD Corporation, Shiga 520-2323 (JP); Osaka Research Institute of Industrial Science and Technology, Izumi-shi, Osaka 594-1157 (JP); Ogawa, Soichi, Kobe-shi, Hyogo 655-0049 (JP)
(72) Inventor: EBE, Akinori, Yasu-shi, Shiga 520-2323 (JP); KONDO, Yusuke, Izumi-shi, Osaka 594-1157 (JP); KAKEHI, Yoshiharu, Izumi-shi, Osaka 594-1157 (JP); SATOH, Kazuo, Izumi-shi, Osaka 594-1157 (JP); IKUHARA, Shiro, Ritto-shi, Shiga 520-3045 (JP); IWASAKI, Shinichi, Ritto-shi, Shiga 520-3045 (JP); OGAWA, Soichi, Kobe-shi, Hyogo 655-0049 (JP)
(74) Representative: Hoeger, Stellrecht & Partner Patentanwälte mbB
(86) International application number: PCT/JP2022/018834
(87) International publication number: WO 2022/230857

(56) References cited:
- JP-A- 2008 127 582
- JP-A- 2017 066 434
- JP-A- 2018 053 272
- JP-A- H01 298 154
- JP-A- H07 238 371
- SAHU BIBHUTI BHUSAN ET AL: "Effect of inductively coupled plasma and plasma parameters on magnetron sputtered Al-Doped ZnO highly conductive thin films at low-temperature", JOURNAL OF APPLIED PHYSICS, AMERICAN INSTITUTE OF PHYSICS, 2 HUNTINGTON QUADRANGLE, MELVILLE, NY 11747, vol. 123, no. 20, 23 May 2018 (2018-05-23), XP012228708, ISSN: 0021-8979, [retrieved on 20180523], DOI: 10.1063/1.5022708
- 平田豊明ほか, 対向ターゲット式スパッタ法によるAl薄膜の特性, 金属表面技術, 1987, vol. 38, no. 9, pages 450-452, https://www.jstage.jst.go.jp/article/sssj2008/30/0/30_0_130/_pdf/-char/ja, particularly, fig. 2, (HIRATA, Toyoaki et al. Properties of Aluminum Thin Films Prepared by Facing Targets Sputtering System. Kinzoku Hyomen Gijutsu.)

## Description

### TECHNICAL FIELD

The present invention relates to a sputtering apparatus configured to form a film by sputtering a raw material of a target by plasma and depositing the material on a substrate.

### BACKGROUND ART

Conventionally, attempts have been made to increase the density of plasma generated near surface of a target for the purpose of increasing the deposition rate in a sputtering apparatus. Fig. 10 illustrates a schematic configuration of an apparatus described in Patent Literature 1 as an example of such a conventional sputtering apparatus.

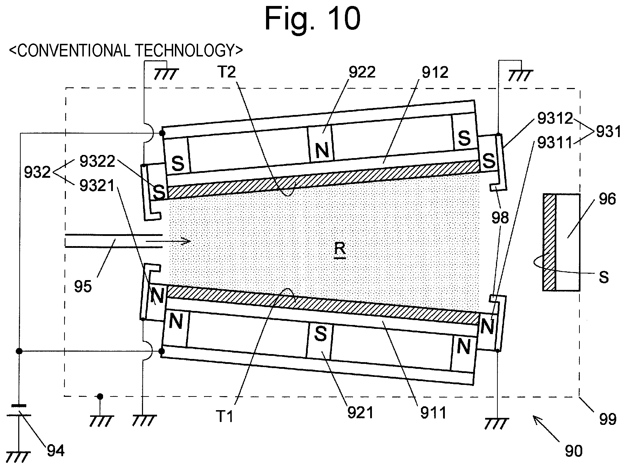

The sputtering apparatus 90 illustrated in Fig. 10 includes: a first target holder 911 and a second target holder 912 in which two plate-shaped targets T1 and T2 are disposed to face each other with a plasma generation region R between them so as to have a larger distance on one end. A first main magnetic field generation unit 921 and a second main magnetic field generation unit 922 are respectively provided on opposite sides of the target T1 and the target T2 (back surface sides of the first target holder 911 and the second target holder 912). The first main magnetic field generation unit 921 and the second main magnetic field generation unit 922 generate a magnetic field (this magnetic field is referred to as "main magnetic field") near surfaces of the targets T1 and T2. A substrate holder 96 is disposed on an end of the plasma generation region R where the distance between the target T1 and the target T2 is larger.

The sputtering apparatus 90 further includes a first auxiliary magnetic field generation unit 931 and a second auxiliary magnetic field generation unit 932. The first auxiliary magnetic field generation unit 931 includes a first-1 auxiliary magnet 9311 provided at an end of the first target holder 911 near the substrate holder 96 and a first-2 auxiliary magnet 9312 provided at an end of the second target holder 912 near the substrate holder 96, and generates a first auxiliary magnetic field directed from the first-1 auxiliary magnet 9311 toward the first-2 auxiliary magnet 9312. The second auxiliary magnetic field generation unit 932 includes a second-1 auxiliary magnet 9321 provided at an end of the first target holder 911 on a side opposite to the substrate holder 96 and a second-2 auxiliary magnet 9322 provided at an end of the second target holder 912 on a side opposite to the substrate holder 96, and generates a second auxiliary magnetic field directed from the second-1 auxiliary magnet 9321 toward the second-2 auxiliary magnet 9322.

The sputtering apparatus 90 further includes: two ground electrodes 98 disposed on each side of the first target holder 911 and the second target holder 912 so as to sandwich the target holders; a DC power supply 94 configured to generate an electric field in the plasma generation region R by applying a voltage between each of the first target holder 911 and the second target holder 912 and the ground electrode 98; and a plasma source gas supply unit 95 configured to supply a plasma source gas (for example, Ar gas) as a source of plasma into the plasma generation region R. Constituents of the sputtering apparatus 90 described above are accommodated in a vacuum vessel 99 except for the DC power supply 94.

In the sputtering apparatus 90, atoms or molecules of the plasma source gas supplied from the plasma source gas supply unit 95 to the plasma generation region R are ionized into cations and electrons by an electric field and a main magnetic field generated in the plasma generation region R, so that plasma is generated. Then, on the surfaces of the targets T1 and T2, trajectories of the cations are bent toward the first target holder 911 and the second target holder 912 by the main magnetic field, and the cations are incident on the surfaces of the targets T1 and T2, so that the targets T1 and T2 are sputtered. The surfaces of the targets T1 and T2 are inclined so as to face the substrate holder 96, so that the sputtered particles thus generated fly mainly toward the substrate holder 96 and are deposited on a surface of a substrate S held by the substrate holder 96. As a result, a film made of the materials of the targets T1 and T2 is produced on the surface of the substrate S.

When the cations and electrons generated in the plasma generation region R fly toward the substrate holder 96 side or the opposite side, their traveling directions are bent so as to return into the plasma generation region R by the Lorentz force received from the first auxiliary magnetic field or the second auxiliary magnetic field. As a result, in the sputtering apparatus 90, cations and electrons are confined in the plasma generation region R, and the plasma density in the plasma generation region R can be increased.

### CITATION LIST

### PATENT LITERATURE

Patent Literature 1: JP 2008-127582 A

### SUMMARY OF INVENTION

### TECHNICAL PROBLEM

In the sputtering apparatus 90, a plasma density in the plasma generation region R can be further increased by increasing the voltage applied by the DC power supply 94. However, when this voltage is increased, an abnormal discharge may occur in the plasma generation region R, and thus, further contrivance is required to increase the plasma density.

JP 2017-66434 A discloses a laminate having a transparent layer and a metallic opaque layer.

JP 2008-127582 A discloses a composite-type sputtering system comprising a pair of magnetron cathodes and an auxiliary magnetic field space having the magnetic line of force going from one target to another target and being generated along the space between the targets.

The article SAHU BIBHUTI BHUSAN ET AL: "Effect of inductively coupled plasma and plasma parameters on magnetron sputtered Al-Doped ZnO highly conductive thin films at low-temperature", JOURNAL OF APPLIED PHYSICS, AMERICAN INSTITUTE OF PHYSICS 2 HUNTINGTON QUADRANGLE, MELVILLE, NY 11747, vol. 123, no. 20, 23 May 2018 (2018-05-23) deals with low-temperature synthesis of highly conductive transparent Al-doped ZnO films using magnetron sputtering with the support of an inductively coupled plasma source.

An object of the present invention is to provide a sputtering apparatus capable of increasing a plasma density and thus increasing a deposition rate.

### SOLUTION TO PROBLEM

A sputtering apparatus according to the present invention made to solve the above problems includes:
a) a first target holder and a second target holder configured to hold a first target and a second target respectively such that surfaces of the first target and the second target face each other;
b) a substrate holder provided on one side of a plasma generation region which is a region between the first target and the second target respectively held by the first target holder and the second target holder;
c) a first main magnetic field generation unit and a second main magnetic field generation unit respectively provided on a side of the first target opposite to the plasma generation region and on a side of the second target opposite to the plasma generation region, the first main magnetic field generation unit and the second main magnetic field generation unit being configured to generate a first main magnetic field and a second main magnetic field respectively on surfaces of the first target and the second target, in which magnets are disposed such that opposite poles face each other;
d) a power supply configured to generate an electric field in the plasma generation region by applying a predetermined potential to each of the first target holder and the second target holder;
e) a radio-frequency electromagnetic field generation unit configured to generate a radio-frequency electromagnetic field in the plasma generation region, which is provided on a side of the plasma generation region facing the substrate holder with the plasma generation region between them;
f) a plasma source gas introduction unit configured to introduce a plasma source gas into the plasma generation region; and
g) an auxiliary magnetic field generation unit configured to generate, at ends of the first target holder and the second target holder on the substrate holder side, an auxiliary magnetic field directed from one side to another side of the first target holder and the second target holder, the auxiliary magnetic field confining cations and electrons in the plasma generation region,
in which means for generating a magnetic field does not exist at ends of the first target holder and the second target holder on a side of the radio-frequency electromagnetic field generation unit.

In the sputtering apparatus according to the present invention, the radio-frequency electromagnetic field, in addition to the electric field and the main magnetic field (the first main magnetic field and the second main magnetic field), acts on atoms or molecules of the plasma source gas supplied from the plasma source gas supply unit to the plasma generation region, so that ionization is promoted.

Means for generating a magnetic field does not exist at the ends of the first target holder and the second target holder on the radio-frequency electromagnetic field generation unit side. That is, in the sputtering apparatus according to the present invention, there is no equivalent for the second auxiliary magnetic field generation unit 932 in the sputtering apparatus 90 described above. This is because when a magnetic field other than the main magnetic field is generated at the end, a radio-frequency electromagnetic field generated by the radio-frequency electromagnetic field generation unit is disturbed, and generation of plasma by the radio-frequency electromagnetic field is prevented. Furthermore, in the present invention, the magnets are disposed such that the opposite poles (N pole and S pole) face each other in the first main magnetic field generation unit and the second main magnetic field generation unit, so that the magnetic fields near the surface of the first target and near the surface of the second target formed by the first main magnetic field and the second main magnetic field have an action of confining cations and electrons in the plasma generation region. Therefore, cations and electrons can be confined in the plasma generation region without providing a magnetic field generation means corresponding to the second auxiliary magnetic field generation unit 932.

With the sputtering apparatus of the present invention, ionization of atoms or molecules of a plasma source gas is promoted by a radio-frequency electromagnetic field generated by the radio-frequency electromagnetic field generation unit while cations and electrons are confined in the plasma generation region as described above, so that the density of the plasma in the plasma generation region can be increased, and thus a deposition rate can be increased.

In the sputtering apparatus according to the present invention, the first target and the second target may be held by the first target holder and the second target holder such that surfaces of the first target and the second target face each other. That is, the two surfaces may be inclined to each other or parallel to each other. In a case where surfaces of the first target and the surface of the second target are not parallel to each other, it is preferable that the substrate holder is disposed on a side of both the targets at a larger distance as described in Patent Literature 1 because more sputtered particles can sputter on the substrate holder side, but the present invention is not limited to it. As described above, even in a case where the first target and the second target are disposed in any orientation, when the targets having the same orientation are compared with each other, the deposition rate can be made faster in the present invention having the radio-frequency electromagnetic field generation unit than in the conventional configuration without the radio-frequency electromagnetic field generation unit.

The first target and/or the second target are not limited to one with a flat shape. For example, it is possible to adopt the following configuration:
one or both of the first target holder and the second target holder is a cylindrical member which holds a cylindrical target on a side surface of the cylindrical member and is rotatable about the axis of the cylinder of the cylindrical member, and
one of the first main magnetic field generation unit and the second main magnetic field generation unit in which the corresponding target holder is the cylindrical target holder is disposed inside the cylindrical member. Sputtering is performed while such a cylindrical target holder is rotated about the axis of the cylinder, so that the entire target can be sputtered almost uniformly, and the utilization efficiency of the target can be increased. Note that since the magnets are disposed such that the opposite poles face each other in the first main magnetic field generation unit and the second main magnetic field generation unit (this state is maintained) as described above, the first main magnetic field generation unit and/or the second main magnetic field generation unit disposed inside the cylindrical member do not rotate with the rotation of the cylindrical member.

The potential applied to the first target holder and the second target holder by the power supply may be a continuously applied DC, or may be a DC (DC pulse) repeatedly applied in a pulse shape or an AC (radio-frequency). The potential applied to one of the first target holder and the second target holder may be a (continuous) DC, and the other may be a DC pulse or an AC.

In the radio-frequency electromagnetic field generation unit, a capacitively coupled antenna (capacitively coupled electrode) which generates a radio-frequency electromagnetic field by applying a radio-frequency voltage between two electrodes or between one electrode and ground, an inductively coupled antenna which generates a radio-frequency electromagnetic field by causing a radio-frequency electric current to flow through a conductor, or the like can be used. In particular, it is preferable to use an inductively coupled antenna which hardly causes abnormal discharge even when a strong radio-frequency electromagnetic field is generated for the radio-frequency electromagnetic field generation unit.

The sputtering apparatus according to the present invention further includes an auxiliary magnetic field generation unit (corresponding to the first auxiliary magnetic field generation unit 931 included in the sputtering apparatus 90 described above) configured to generate an auxiliary magnetic field directed from one side to the other side of the first target holder and the second target holder at ends of the first target holder and the second target holder on the substrate holder side. As a result, cations and electrons can be confined in the plasma generation region. Furthermore, unlike the end on the radio-frequency electromagnetic field side, even when such an auxiliary magnetic field is generated at the end on the substrate holder side of the plasma generation region, the generation of plasma by the radio-frequency electromagnetic field generated by the radio-frequency electromagnetic field generation unit is not prevented. Therefore, by providing the auxiliary magnetic field generation unit on the substrate holder side, the plasma density can be further increased.

The sputtering apparatus according to the present invention can adopt a configuration in which one of the first main magnetic field generation unit and the second main magnetic field generation unit includes one or a plurality of permanent magnets, and one pole (N pole or S pole) of the one or the plurality of the first permanent magnets faces the plasma generation space side, and the other of the first main magnetic field generation unit and the second main magnetic field generation unit includes one or a plurality of permanent magnets, and the other pole of the one or the plurality of second permanent magnets faces the plasma generation space side (the other pole is the S pole when the N pole of the first permanent magnet is directed toward the plasma generation space, and the other pole is the N pole when the S pole of the first permanent magnet is directed toward the plasma generation space). As a result, cations and electrons can be easily confined in the plasma generation region sandwiched between the first target holder and the second target holder as compared with a case where magnetrons used in many sputtering apparatuses are the first main magnetic field generation unit and the second main magnetic field generation unit. Therefore, the density of the plasma in the plasma generation space can be further increased.

### ADVANTAGEOUS EFFECTS OF INVENTION

With the sputtering apparatus of the present invention, the plasma density can be increased, and thus the deposition rate is increased.

### BRIEF DESCRIPTION OF DRAWINGS

[Fig. 1] Fig. 1 is a schematic configuration diagram illustrating a first embodiment of a sputtering apparatus according to the present invention.
[Fig. 2] Fig. 2 is a schematic configuration diagram illustrating a second embodiment of a sputtering apparatus according to the present invention.
[Fig. 3] Fig. 3 is a plan view illustrating a configuration for supplying a radio-frequency electric current to an inductively coupled antenna 27 included in the sputtering apparatus of the second embodiment.
[Fig. 4] Fig. 4 is a schematic configuration diagram illustrating a sputtering apparatus of a comparative example.
[Fig. 5A] Fig. 5A is a graph illustrating a result of measuring intensities of components perpendicular and parallel to a center line of a magnetic flux density on the dashed-dotted line (center line) of Fig. 2 in the sputtering apparatus of the second embodiment.
[Fig. 5B] Fig. 5B is a graph illustrating a result of measuring intensities of components perpendicular and parallel to a center line of a magnetic flux density on the dashed-dotted line (center line) of Fig. 4 in the sputtering apparatus of the comparative example.
[Fig. 6] Fig. 6 is a photograph illustrating an example of a film prepared by the sputtering apparatus of the second embodiment and the comparative example.
[Fig. 7] Fig. 7 is a graph illustrating results of measuring deposition rates in the sputtering apparatuses of the second embodiment and the comparative example.
[Fig. 8] Fig. 8 is a schematic cross-sectional view illustrating a third embodiment of the sputtering apparatus according to the present invention.
[Fig. 9] Fig. 9 is a schematic configuration diagram illustrating a modification of the sputtering apparatus of the second embodiment not forming part of the invention.
[Fig. 10] Fig. 10 is a schematic configuration diagram illustrating an example of a conventional sputtering apparatus.

### DESCRIPTION OF EMBODIMENTS

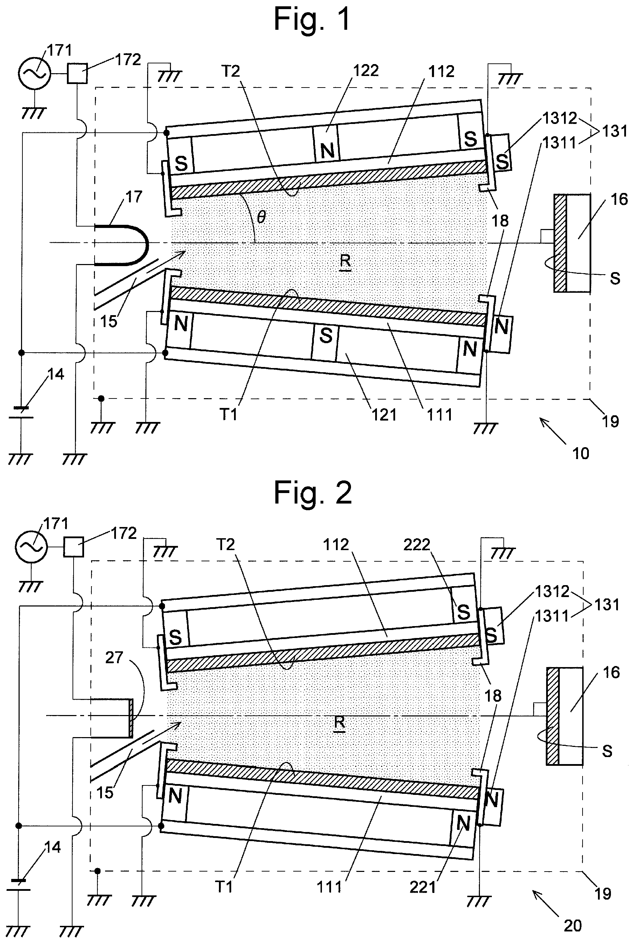

Embodiments of a sputtering apparatus according to the present invention will be described with reference to Figs. 1 to 9.

### (1) First Embodiment

### (1-1) Configuration of Sputtering Apparatus of First Embodiment

The sputtering apparatus 10 of the first embodiment illustrated in Fig. 1 includes a first target holder 111, a second target holder 112, a substrate holder 16, a first main magnetic field generation unit 121, a second main magnetic field generation unit 122, an auxiliary magnetic field generation unit 131, a DC power supply (corresponding to the power supply) 14, an inductively coupled antenna (radio-frequency electromagnetic field generation unit) 17, a plasma source gas introduction unit 15, and a radio-frequency power supply (a power supply different from the above power supply) 171. Each of the constituents, except for the DC power supply 14 and the radio-frequency power supply 171, is accommodated in a vacuum vessel 19. During operation of the sputtering apparatus 10, an atmosphere in the vacuum vessel 19 is discharged by a vacuum pump (not illustrated).

Both the first target holder 111 and the second target holder 112 hold plate-shaped targets (one held by the first target holder 111 is a first target T1, and one held by the second target holder 112 is a second target T2), and have a function of an electrode to which a potential having a negative predetermined value is applied by the DC power supply 14. The first target holder 111 and the second target holder 112 are disposed such that the surface of the second target T2 held by the second target holder 112 faces in an inclined direction with respect to the surface of the first target T1 held by the first target holder 111.

Since plasma is generated in a region between the first target T1 held by the first target holder 111 and the second target T2 held by the second target holder 112, this region is referred to as plasma generation region R.

The substrate holder 16 is provided on the side of the plasma generation region R on a side of the first target T1 and the second target T2 at a larger distance (on the right side of the plasma generation region R in Fig. 1). The surface of the substrate holder 16 faces the plasma generation region R, and the substrate S is held on the surface. In the present embodiment, an angle formed by a normal line (a dashed-dotted line in Fig. 1) of a surface of the substrate holder 16 and the surface of the first target holder 111 and an angle θ formed by the normal line and a surface of the second target holder 112 are both set to 10° (therefore, an angle 2θ formed by the surface of the first target holder 111 and the surface of the second target holder 112 is set to 20°). The angle θ is not limited to 10°, but it is preferable that the angle θ is 22.5° or less (2θ is 45° or less) so that the opening on the substrate holder 16 side of the plasma generation region R does not become too large.

The first main magnetic field generation unit 121 is provided on the back surface (that is, opposite to the plasma generation region R with the first target T1 between them) side of the first target holder 111, and generates a magnetic field in the plasma generation region R including the surface of the first target T1. Similarly, the second main magnetic field generation unit 122 is provided on the back surface (that is, opposite to the plasma generation region R with the second target T2 between them) side of the second target holder 112, and generates a magnetic field in the plasma generation region R including the surface of the second target T2. In the present embodiment, magnetrons made of permanent magnets are used for the first main magnetic field generation unit 121 and the second main magnetic field generation unit 122. The magnetron is a magnetic field generation apparatus that has been used in many sputtering apparatuses. In the first main magnetic field generation unit 121, a magnet is disposed at a position corresponding to the center of the first target holder 111 so that the S pole faces the plasma generation region R side, and a magnet is disposed at a position corresponding to two ends of the first target holder 111 facing each other so that the N pole faces the plasma generation region R side. In the second main magnetic field generation unit 122, a magnet is disposed at a position corresponding to the center of the second target holder 112 such that the N pole faces the plasma generation region R side, and a magnet is disposed at a position corresponding to two ends of the second target holder 112 facing each other such that the S pole faces the plasma generation region R side. As a result, the magnets of the first main magnetic field generation unit 121 and the second main magnetic field generation unit 122 are disposed such that opposite poles face each other with the plasma generation region R between them. Note that the magnets may be disposed such that the poles of all the magnets of the first main magnetic field generation unit 121 and the second main magnetic field generation unit 122 are opposite to those described above.

The first target holder 111, the second target holder 112, the first main magnetic field generation unit 121, and the second main magnetic field generation unit 122 are each provided with a cooling water supply mechanism (not illustrated) for cooling them.

The auxiliary magnetic field generation unit 131 is a permanent magnet provided at an end of the first target holder 111 and the second target holder 112 closer to the substrate holder 16, and generates a magnetic field (referred to as "auxiliary magnetic field") directed from one side to the other side of the first target holder 111 and the second target holder 112 at an end of the plasma generation region R closer to the substrate holder 16. In the example illustrated in Fig. 1, the auxiliary magnetic field generation unit 131 includes a first auxiliary magnet 1311 provided in the first target holder 111 and disposed such that the N pole faces the plasma generation region R side (in the same direction as the magnets at both ends in the first main magnetic field generation unit 121), and a second auxiliary magnet 1312 provided in the second target holder 112 and disposed such that the S pole faces the plasma generation region R side (in the same direction as the magnets at both ends in the second main magnetic field generation unit 122). Note that when the magnets of the first main magnetic field generation unit 121 and the second main magnetic field generation unit 122 are disposed in directions opposite to those in the above example, the first auxiliary magnet 1311 and the second auxiliary magnet 1312 are also disposed in directions opposite to those in the above example.

An auxiliary magnetic field generation unit similar to the auxiliary magnetic field generation unit 131 is not provided at the ends of the first target holder 111 and the second target holder 112 on the side opposite to the substrate holder 16 (inductively coupled antenna 17 side).

The DC power supply 14 is connected in parallel to the first target holder 111 and the second target holder 112, and continuously applies a negative DC potential to the two target holders. As a result, a DC electric field with respect to the ground is generated in the plasma generation region R including the surfaces of the first target T1 and the second target T2. Note that instead of the DC power supply 14, a DC pulse power supply or a radio-frequency power supply (different from the radio-frequency power supply 171) may be used to apply a radio-frequency voltage between the first target holder 111 and the second target holder 112 and the ground, and thus a radio-frequency electric field may be generated in the plasma generation region R.

The inductively coupled antenna 17 is provided on the side of the plasma generation region R at a position facing the substrate holder 16 with the plasma generation region R between them. In the present embodiment, the inductively coupled antenna 17 is made of a U-shaped linear conductor, and a radio-frequency electric current supplied from the radio-frequency power supply 171 flows through the linear conductor, so that a radio-frequency electromagnetic field is generated in a region including the plasma generation region R. An impedance matcher 172 is provided between the radio-frequency power supply 171 and the inductively coupled antenna 17.

Two ground electrodes 18 grounded are disposed on each side of the first target holder 111 and the second target holder 112 so as to sandwich the target holders. Furthermore, a wall of the vacuum vessel 19 is made of a conductive material and is grounded.

The plasma source gas introduction unit 15 introduces a plasma source gas into the plasma generation region R. In the present embodiment, an Ar (argon) gas or a mixed gas of Ar and N₂ (nitrogen) is used as a plasma source gas.

### (1-2) Operation of Sputtering Apparatus of First Embodiment

Hereinafter, the operation of the sputtering apparatus 10 will be described. First, the first target holder 111 holds the first target T1, the second target holder 112 holds the second target T2, and the substrate holder 16 holds the substrate S. In this state, the gas (atmosphere) in the vacuum vessel 19 is discharged to the outside by a vacuum pump. Then, a plasma source gas is supplied from the plasma source gas introduction unit 15 into the plasma generation region R.

In addition, the DC power supply 14 applies a DC voltage between the first target holder 111 and the second target holder 112 and between the ground electrode 18 and the wall (grounded as described above) of the vacuum vessel 19, so that a DC electric field is generated in the plasma generation region R. Furthermore, a radio-frequency electric current is caused to flow from the radio-frequency power supply 171 to the inductively coupled antenna 17, so that a radio-frequency electromagnetic field is generated in the plasma generation region R. The first main magnetic field generation unit 121 and the second main magnetic field generation unit 122 generate a main magnetic field in the plasma generation region R. An auxiliary magnetic field is generated by the auxiliary magnetic field generation unit 131 near the end of the plasma generation region R on the substrate holder 16 side.

Atoms or molecules of the plasma source gas are ionized into cations and electrons by a DC electric field, a radio-frequency electromagnetic field, and a main magnetic field. As a result, plasma is generated. Then, on the surfaces of the targets T1 and T2, cations are attracted toward the target surfaces by the electric fields (DC, DC pulse, or radio-frequency) applied to the targets T1 and T2, and the cations are incident on the surfaces of the targets T1 and T2. As a result, the targets T1 and T2 are sputtered. Since the surfaces of the targets T1 and T2 are inclined so as to face the substrate holder 16 side, the sputtered particles thus generated fly mainly toward the substrate holder 16 side and are deposited on the surface of the substrate S held by the substrate holder 16. As a result, a film made of the materials of the targets T1 and T2 is produced on the surface of the substrate S.

In the sputtering apparatus 10 of the present embodiment, the radio-frequency electromagnetic field by the inductively coupled antenna 17 acts in addition to the DC electric field and the main magnetic field, so that ionization of atoms or molecules of the plasma source gas can be promoted as compared with a case where the inductively coupled antenna 17 is not provided.

Of cations and electrons generated in the plasma generation region R, those flying toward the substrate holder 16 are bent in the traveling direction so as to return into the plasma generation region R by the Lorentz force received from the auxiliary magnetic field generated near the end on the substrate holder 16 side of the plasma generation region R by the auxiliary magnetic field generation unit 131. As a result, cations and electrons can be confined in the plasma generation region R. Therefore, electrons and charged particles in the plasma are suppressed from flying to the surface of the substrate S, and the temperature of the surface of the substrate S can be suppressed from rising. On the other hand, no auxiliary magnetic field is generated near the end of the plasma generation region R on the inductively coupled antenna 17 side. However, among cations and electrons, those flying toward the inductively coupled antenna 17 can be confined in the plasma generation region R by the magnetic fields near the surfaces of the first target T1 and the second target T2 formed by the first main magnetic field generation unit 121 and the second main magnetic field generation unit 122.

As described above, with the sputtering apparatus 10 of the present embodiment, cations and electrons are confined in the plasma generation region R by the components of the magnetic field from one side to the other side of the first target holder 111 and the second target holder 112 included in the auxiliary magnetic field and the main magnetic field generated by the auxiliary magnetic field generation unit 131 while ionization of atoms or molecules of the plasma source gas is promoted by the inductively coupled antenna 17, so that a plasma density in the plasma generation region R can be increased.

In the sputtering apparatus 10 of the present embodiment, if an auxiliary magnetic field directed from one side to the other side of the first target holder 111 and the second target holder 112 is generated at the end on the inductively coupled antenna 17 side of the plasma generation region R, a radio-frequency electromagnetic field generated by the inductively coupled antenna 17 is disturbed, and a generation of plasma by the radio-frequency electromagnetic field is prevented. Then, a plasma density in the plasma generation region R cannot be increased. Therefore, as described above, in the sputtering apparatus 10 of the present embodiment, an auxiliary magnetic field generation unit is not provided at the ends of the first target holder 111 and the second target holder 112 on the inductively coupled antenna 17 side.

### (2) Second Embodiment

### (2-1) Configuration and Operation of Sputtering Apparatus of Second Embodiment

Fig. 2 illustrates a configuration of a sputtering apparatus 20 of the second embodiment. The sputtering apparatus 20 has the same configuration as that of the sputtering apparatus 10 of the first embodiment except that the configurations of the first main magnetic field generation unit 221, the second main magnetic field generation unit 222, and the inductively coupled antenna 27 are different from the configurations of the first main magnetic field generation unit 121, the second main magnetic field generation unit 122, and the inductively coupled antenna 17 in the sputtering apparatus 10 of the first embodiment. Therefore, only the configurations of the first main magnetic field generation unit 221, the second main magnetic field generation unit 222, and the inductively coupled antenna 27 will be described below.

The first main magnetic field generation unit 221 includes a plurality of permanent magnets, and all of the plurality of permanent magnets have the same pole (N pole in an example illustrated in Fig. 2) facing a plasma generation region R. The second main magnetic field generation unit 222 also includes a plurality of permanent magnets, and all of the plurality of permanent magnets have the same pole, and the pole (S pole in the example illustrated in Fig. 2) opposite to the pole of the plurality of permanent magnets of the first main magnetic field generation unit 221 faces the plasma generation region R side. With such a configuration, a main magnetic field directed from one of the first main magnetic field generation unit 221 and the second main magnetic field generation unit 222 to the other is generated over the entire plasma generation region R. Due to such a main magnetic field, cations and electrons flying toward the substrate holder 16 side or the inductively coupled antenna 27 side receive the Lorentz force from the main magnetic field and are bent in the traveling direction, and these cations and electrons can be confined in the plasma generation region R. Note that similarly to the first embodiment, the first main magnetic field generation unit 221 and the second main magnetic field generation unit 222 are each also provided with a cooling mechanism (not illustrated) using cooling water.

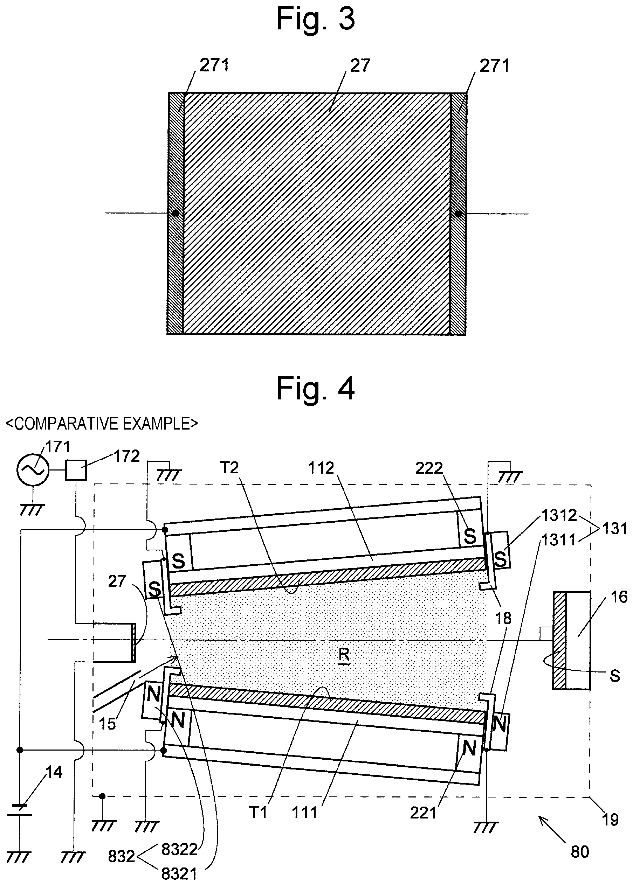

The inductively coupled antenna 27 is a planar antenna made of a metal plate of a good conductor such as copper. Note that a metal fiber sheet may be used for the inductively coupled antenna 27 in that it is hardly affected by thermal expansion. In the present embodiment, the inductively coupled antenna 27 has a rectangular shape, and a radio-frequency electric current is introduced through the rod-shaped power supply terminal 271 attached along both short sides (Fig. 3).

The operation of the sputtering apparatus 20 of the second embodiment is basically similar to the operation of the sputtering apparatus 10 of the first embodiment. As described above, since cations and electrons can be confined in the plasma generation region R by the main magnetic field generated by the first main magnetic field generation unit 221 and the second main magnetic field generation unit 222, a plasma density in the plasma generation region R can be further increased.

### (2-2) Experiment by sputtering apparatus of second embodiment and comparative example

Next, results of experiments performed using a sputtering apparatus 20 of the second embodiment and a sputtering apparatus 80 of the comparative example illustrated in Fig. 4 are indicated. The sputtering apparatus 80 of the comparative example is obtained by adding a second auxiliary magnetic field generation unit 832 to the sputtering apparatus 20 of the second embodiment. The second auxiliary magnetic field generation unit 832 includes a second-1 auxiliary magnet 8321 that is a permanent magnet provided at an end of the first target holder 111 near the inductively coupled antenna 27 and a second-2 auxiliary magnet 8322 that is a permanent magnet provided at an end of the second target holder 112 near the inductively coupled antenna 27. The second-1 auxiliary magnet 8321 is disposed such that the N pole faces the plasma generation region R side, and the second-2 auxiliary magnet 8322 is disposed such that the S pole faces the plasma generation region R side.

### <First Experiment>

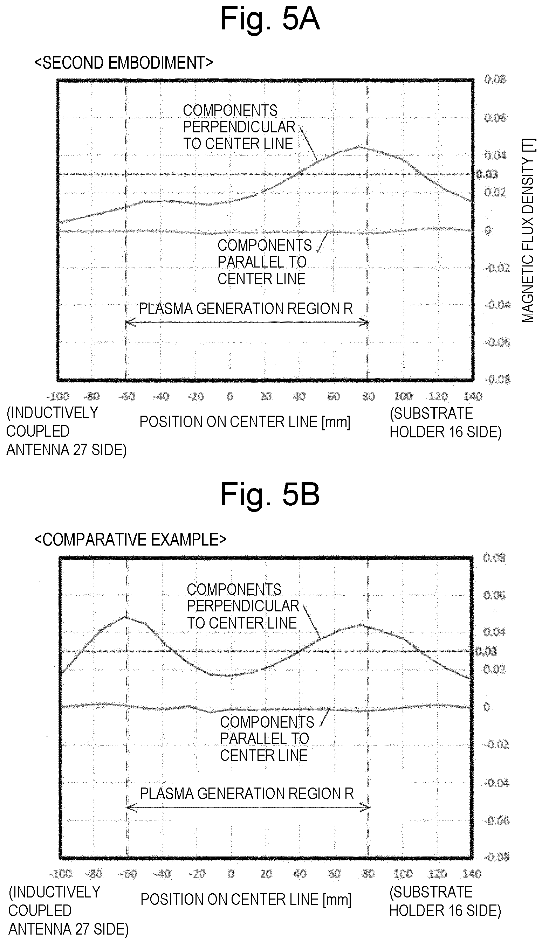

First, for each of the sputtering apparatus 20 of the second embodiment and the sputtering apparatus 80 of the comparative example, the intensity of a component (vertical component) in a direction perpendicular to a center line (dashed-dotted line in Figs. 2 and 4) and a component (parallel component) in a direction parallel to the center line of a magnetic flux density at each position on the center line, which is a normal line of the surface of the substrate holder 16 and a line equidistant from the surface of the first target holder 111 and the surface of the second target holder 112, was measured. Fig. 5A illustrates measurement results of the sputtering apparatus 20 of the second embodiment, and Fig. 5B illustrates the measurement results of the sputtering apparatus 80 of the comparative example. In both cases, the vertical component of the magnetic flux density is sufficiently larger than the parallel component. In the second embodiment, the vertical component (component of magnetic flux density from one end of the first target holder 111 and the second target holder 112 on the substrate holder 16 side to the other end on the substrate holder 16 side) of the magnetic flux density near the end of the plasma generation region R on the substrate holder 16 side is larger than that of other portions, and is 0.03 T or more. In contrast, the vertical component (component of magnetic flux density from end on inductively coupled antenna 27 side of one of first target holder 111 and second target holder 112 toward end on inductively coupled antenna 27 side of the other) of the magnetic flux density near the end of the plasma generation region R on the inductively coupled antenna 27 side is smaller than that of the other portions, and is 0.015 T or less. On the other hand, in the comparative example, the vertical component of the magnetic flux density is larger than that of other portions at both ends of the plasma generation region R on the substrate holder 16 side and the inductively coupled antenna 27 side, and is 0.03 T or more.

### <Second Experiment>

For each of the sputtering apparatus 20 of the second embodiment and the sputtering apparatus 80 of the comparative example, Ar gas was supplied at a flow rate of 100 sccm as a plasma source gas, and under the condition of a pressure of 0.5 Pa, a radio-frequency power (a frequency of 13.56 MHz) was supplied from the radio-frequency power supply 171 to the inductively coupled antenna 27 while a pulsed DC voltage with an ON time of 3 ms and a voltage of -220 V at the ON time was applied to between the first target holder 111 and the ground and between the second target holder 112 and the ground at a repetition frequency of 80 kHz by the DC power supply 14. In the sputtering apparatus 20 of the second embodiment, it has been confirmed that plasma by an inductively coupled antenna is stably generated within a range of radio-frequency power of 100 to 1500 W. In particular, if a radio-frequency power is 1100 W or more, it is estimated that the plasma in the inductively coupled mode is generated from a change in a matching position in the impedance matcher 172. On the other hand, in the sputtering apparatus 80 of the comparative example, plasma could not be stably generated by the inductively coupled antenna 27 even when the radio-frequency power was within a range of 100 to 600 W. This is considered to be due to an influence of a difference in the magnetic field structure in the vicinity of the inductively coupled antenna 27 from that of the sputtering apparatus 20 of the present embodiment, and indicates that optimization of the magnetic field structure in the vicinity of the inductively coupled antenna is important.

### <Third Experiment>

Next, an experiment was conducted in the sputtering apparatus 20 of the second embodiment, in which targets T1 and T2 made of Al are mounted on the first target holder 111 and the second target holder 112, and while, as a plasma source gas, a mixed gas of Ar and N₂ (the content of N₂ is within a range of 0 to 40%. The plasma source gas with the content of N₂ being 0% was Ar gas.) was supplied, a DC voltage was applied by the DC power supply 14 under the same conditions as in the second experiment, and a radio-frequency power of 2000 W and a frequency of 13.56 MHz was supplied from the radio-frequency power supply 171 to the inductively coupled antenna 27. A similar experiment was performed for the sputtering apparatus 80 of the comparative example, but since it was confirmed that the inductively coupled plasma using the inductively coupled antenna 27 was not generated by the second experiment, the radio-frequency power was not supplied to the inductively coupled antenna 27. Therefore, the comparative example is substantially similar to the conventional sputtering apparatus 90 without the inductively coupled antenna 27.

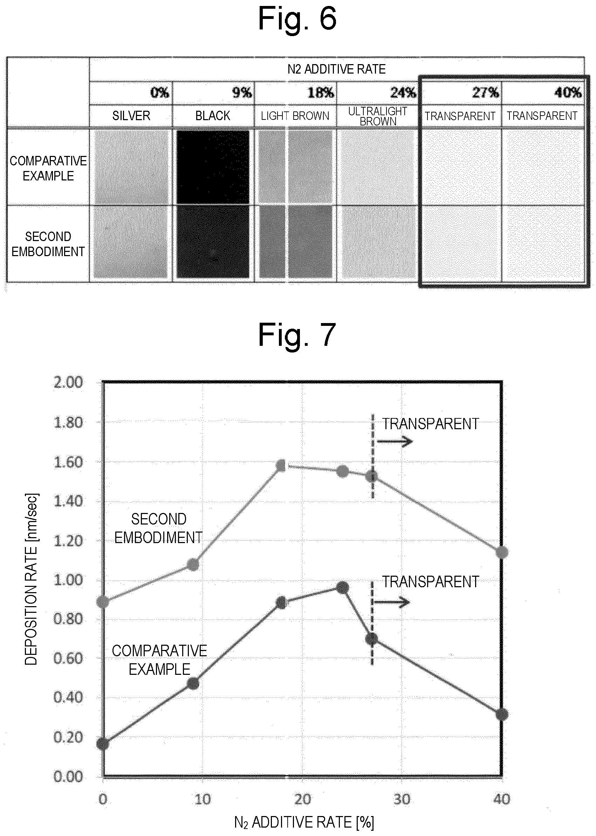

A photograph of a film obtained by this experiment is illustrated in Fig. 6. In both the second embodiment and the comparative example, a silver film is obtained when the content of N₂ is 0%, and a transparent film is obtained when the content of N₂ is 27% and 40%. The silver film is a single Al film, and the transparent film is an AlN film.

For the second embodiment and the comparative example, the results of measuring the deposition rate (value obtained by dividing the obtained film thickness by the time required for film formation) in the experiment are illustrated in Fig. 7. It can be seen that the deposition rate of the second embodiment is faster than that of the comparative example in either case of the values for the content of N₂.

### (3) Third Embodiment

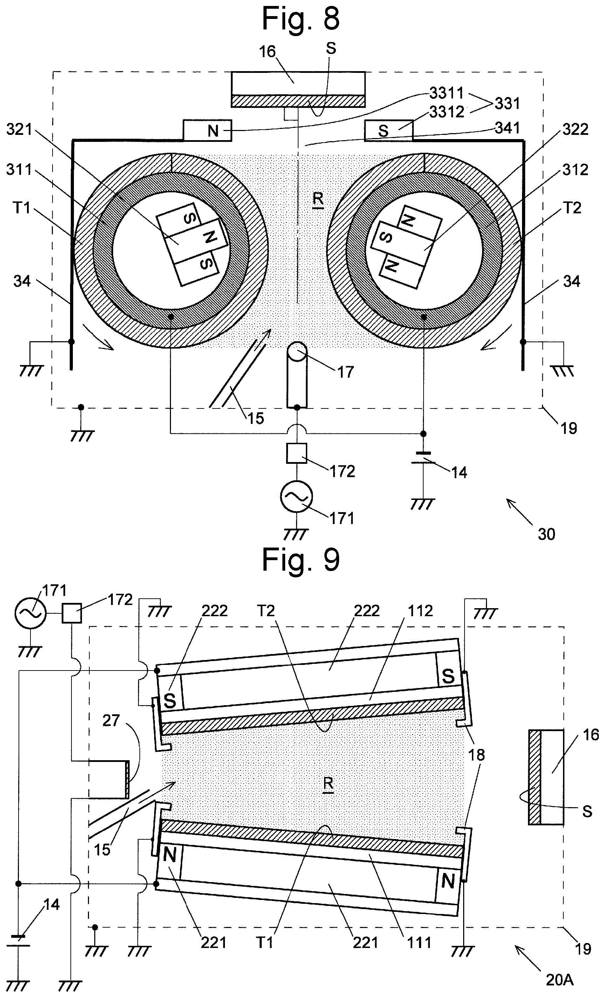

Fig. 8 illustrates a configuration of a sputtering apparatus 30 of the third embodiment. In the sputtering apparatus 30, the configurations of the first target holder 311, the second target holder 312, the first main magnetic field generation unit 321, and the second main magnetic field generation unit 322 are different from the configurations of the first target holder 111, the second target holder 112, the first main magnetic field generation unit 211, and the second main magnetic field generation unit 212 in the sputtering apparatus 10 of the first embodiment.

The first target holder 311 is made of a cylindrical member. Fig. 8 illustrates the entire sputtering apparatus 30 in a cross section perpendicular to an axis of the cylindrical member. The cylindrical member extends in a direction perpendicular to the paper surface of Fig. 8. The target T1 is held over an entire circumference of the side surface of the cylindrical member. The first target holder 311 can be rotated about the axis of the cylinder using a motor (not illustrated). The second target holder 312 can also have the same configuration as that of the first target holder 311, and the target T2 can be held over an entire circumference of the side surface of the cylinder, and can be rotated about the axis of the cylinder. As the first target holder 311 and the second target holder 312 rotate, the targets T1 and T2 also rotate. Both the first target holder 311 and the second target holder 312 are made of a conductive material, and are in contact with a conductive wire connected to the DC power supply 14 while sliding during rotation.

The first main magnetic field generation unit 321 is provided inside a cylinder of the first target holder 311, and three magnets are disposed side by side in a direction inclined with respect to an intermediate line (a line perpendicular to the surface of the substrate holder 16. A dashed-dotted line in Fig. 8.) between the first target holder 311 and the second target holder 312. The magnetic poles of the three magnets are disposed such that the S pole, the N pole, and the S pole face the outside of the cylinder. The second main magnetic field generation unit 322 is provided inside the cylinder of the second target holder 312, and three magnets are disposed so as to be symmetric with the first main magnetic field generation unit 321 with respect to the intermediate line. However, the magnetic poles of the three magnets of the second main magnetic field generation unit 322 have opposite polarities to those of the three magnets of the first main magnetic field generation unit 321 facing each other, and are disposed in the order of the N pole, the S pole, and the N pole. Note that the first main magnetic field generation unit 321 and the second main magnetic field generation unit 322 do not rotate (even when the first target holder 311 and the second target holder 312 rotate).

Cooling water flows inside the cylinders of the first target holder 311 and the second target holder 312, and the targets T1 and T2, the first main magnetic field generation unit 321, and the second main magnetic field generation unit 322 are cooled.

The sputtering apparatus 30 of the third embodiment is further provided with a shield plate 34 having a ground potential outside the first target holder 311 and the second target holder 312. In the shield plate 34, the inductively coupled antenna 17 side is opened, and an opening 341 is provided at a position facing the substrate holder 16. Furthermore, the sputtering apparatus 30 is provided with an auxiliary magnetic field generation unit 331 in which a first auxiliary magnet 3311 and a second auxiliary magnet 3312 are disposed such that different poles face each other with the opening 341 between them. By disposing the auxiliary magnetic field generation unit 331 in this manner, lines of magnetic force in the horizontal direction are formed with respect to the opening 341 of the shield plate 34, and plasma generated between the first target holder 311 and the second target holder 312 is confined. Therefore, electrons and charged particles in the plasma are suppressed from flying to the surface of the substrate S, and the temperature of the surface of the substrate S can be suppressed from rising.

An auxiliary magnetic field generation unit similar to the auxiliary magnetic field generation unit 331 is not provided at the ends of the first target holder 311 and the second target holder 312 on the side opposite to the substrate holder 16 (inductively coupled antenna 17 side). Note that, although the sputtering apparatus 30 of the third embodiment is not provided with one corresponding to the ground electrode 18, the ground electrode may be provided in the vicinity of the first target holder 311 and the second target holder 312.

The operation of the sputtering apparatus 30 of the third embodiment is similar to the operation of the sputtering apparatus 10 of the first embodiment except that the first target holder 311 and the second target holder 312 are rotated during the sputtering processing. By rotating the first target holder 311 and the second target holder 312 in this manner, the entire targets T1 and T2 held by them can be uniformly sputtered.

### (4) Modifications

The present invention is not limited to the above embodiments, and various variations are possible, as long as they fall under the scope of the invention, which is defined by the claims.

For example, in the sputtering apparatus 10 of the first embodiment and the sputtering apparatus 30 of the third embodiment, the metal plate or the inductively coupled antenna 27 with a planar shape and metal fibers used in the second embodiment may be used instead of the U-shaped inductively coupled antenna 17. Furthermore, the inductively coupled antenna is not limited to a U-shaped or planar antenna, and a coil in which a linear conductor is wound many times or another inductively coupled antenna may be used.

As a radio-frequency electromagnetic field generation unit, a capacitively coupled antenna (electrode) may be used instead of an inductively coupled antenna. However, the inductively coupled antenna is more preferable than the capacitively coupled antenna because abnormal discharge is less likely to occur even when a strong radio-frequency electromagnetic field is generated.

In the sputtering apparatus 10 of the first embodiment, instead of the first main magnetic field generation unit 121 and the second main magnetic field generation unit 122 which are magnetrons, the first main magnetic field generation unit 221 and the second main magnetic field generation unit 222 used in the second embodiment may be used. Furthermore, the first main magnetic field generation unit and the second main magnetic field generation unit in each embodiment are not limited to the above example, and various magnetic field generation means can be used.

In each of the first main magnetic field generation unit 221 and the second main magnetic field generation unit 222 used in the sputtering apparatus 20 of the second embodiment and the first main magnetic field generation unit 321 and the second main magnetic field generation unit 322 used in the sputtering apparatus 30 of the third embodiment, a plurality of permanent magnets are used, but only one permanent magnet may be used in one or both of the main magnetic field generation units.

Fig.9 illustrates an example of a sputtering apparatus 20 not forming part of the invention, in which the auxiliary magnetic field generation unit 131 is omitted.

In the sputtering apparatus 10 of the first embodiment and the sputtering apparatus 20 of the second embodiment, the two target holders are disposed such that the two flat plate-shaped targets are not parallel to each other, but they may be disposed in parallel to each other. Furthermore, in the sputtering apparatus 30 of the third embodiment, the two target holders are disposed such that the axes of the two cylindrical targets are parallel to each other, but they may be disposed in nonparallel to each other.

In the sputtering apparatus 10 of the first embodiment and the sputtering apparatus 20 of the second embodiment, two flat plate-shaped targets are used, and in the sputtering apparatus 30 of the third embodiment, two cylindrical targets are used, but one of the two targets may have a flat plate shape and the other may have a cylindrical shape.

### REFERENCE SIGNS LIST

10, 20, 20A, 30, 80, 90... Sputtering Apparatus
111, 311, 911... First Target Holder
112, 312, 912... Second Target Holder
121, 221, 321, 921... First Main Magnetic Field Generation Unit
122, 222, 322, 922... Second Main Magnetic Field Generation Unit
131, 331... Auxiliary Magnetic Field Generation Unit
1311, 3311... First Auxiliary Magnet
1312, 3312... Second Auxiliary Magnet
14, 94... DC Power Supply
15, 95... Plasma Source Gas Introduction Unit
16, 96... Substrate Holder
17, 27... Inductively Coupled Antenna
171... Radio-Frequency Power Supply
172... Impedance Matcher
18, 98... Ground Electrode
19, 99... Vacuum Vessel
271... Power Feeding Terminal
832, 932... Second Auxiliary Magnetic Field Generation Unit
8321, 9321... Second-1 Auxiliary Magnet
8322, 9322... Second-2 Auxiliary Magnet
931... First Auxiliary Magnetic Field Generation Unit
9311... First-1 Auxiliary Magnet
9312... First-2 Auxiliary Magnet
R... Plasma Generation Region
S... Substrate
T1... First Target
T2... Second Target

## Claims

1. A sputtering apparatus (10, 20, 30) comprising:
a) a first target holder (111, 311) and a second target holder (112, 312) configured to hold a first target (T1) and a second target (T2) respectively such that surfaces of the first target and the second target face each other;
b) a substrate holder (16) provided on one side of a plasma generation region which is a region between the first target and the second target respectively held by the first target holder and the second target holder;
c) a first main magnetic field generation unit (121, 221, 321) and a second main magnetic field generation unit (122, 222, 322) respectively provided on a side of the first target opposite to the plasma generation region and on a side of the second target opposite to the plasma generation region, the first main magnetic field generation unit and the second main magnetic field generation unit being configured to generate a first main magnetic field and a second main magnetic field respectively on surfaces of the first target and the second target, wherein magnets are disposed such that opposite poles face each other;
d) a power supply (14) configured to generate an electric field in the plasma generation region by applying a predetermined potential to each of the first target holder and the second target holder;
e) a radio-frequency electromagnetic field generation unit (171) configured to generate a radio-frequency electromagnetic field in the plasma generation region, which is provided on a side of the plasma generation region facing the substrate holder with the plasma generation region between them;
f) a plasma source gas introduction unit (15) configured to introduce a plasma source gas into the plasma generation region; and **characterised in that** the sputter apparatus (10, 20, 30) further comprises
g) an auxiliary magnetic field generation unit (131, 331) configured to generate, at ends of the first target holder and the second target holder on the substrate holder side, an auxiliary magnetic field directed from one side to another side of the first target holder and the second target holder, the auxiliary magnetic field confining cations and electrons in the plasma generation region,
wherein means for generating a magnetic field does not exist at ends of the first target holder and the second target holder on a side of the radio-frequency electromagnetic field generation unit.

2. The sputtering apparatus according to claim 1, wherein the first target holder and the second target holder respectively hold the first target and the second target such that surfaces of the first target and the second target face each other in an inclined manner.

3. The sputtering apparatus according to claim 2, wherein a distance between the first target and the second target is larger on the side closer to the substrate holder than on the side closer to the radio-frequency electromagnetic field generation unit.

4. The sputtering apparatus according to claim 1, wherein
one or both of the first target holder and the second target holder is a cylindrical member which holds a cylindrical target on a side surface of the cylindrical member and is rotatable about an axis of a cylinder of the cylindrical member, and
one of the first main magnetic field generation unit and the second main magnetic field generation unit in which the corresponding target holder is the cylindrical target holder is disposed inside the cylindrical member.

5. The sputtering apparatus according to any one of claims 1 to 4, wherein the radio-frequency electromagnetic field generation unit is an inductively coupled radio-frequency antenna.

6. The sputtering apparatus according to any one of claims 1 to 5, wherein one of the first main magnetic field generation unit and the second main magnetic field generation unit includes one or a plurality of permanent magnets, and one pole of the one or the plurality of first permanent magnets faces the plasma generation space side, and another one of the first main magnetic field generation unit and the second main magnetic field generation unit includes one or a plurality of permanent magnets, and another pole of the one or the plurality of second permanent magnets faces the plasma generation space side.

7. The sputtering apparatus according to any one of claims 1 to 6, wherein
a magnitude of a component of a magnetic flux density from an end of one of the first target holder and the second target holder on the substrate holder side to an end of another one of the first target holder and the second target holder on the substrate holder side is 0.03 T or more, and
a magnitude of a component of a magnetic flux density from an end of one of the first target holder and the second target holder on a side of the radio-frequency electromagnetic field generation unit toward an end of another one of the first target holder and the second target holder on a side of the radio-frequency electromagnetic field generation unit is 0.015 T or less.

8. The sputtering apparatus according to claim 1, wherein the auxiliary magnetic field generation unit comprises:
a first auxiliary magnet provided at the end of the first target holder that is closer to the substrate holder, and
a second auxiliary magnet provided at the end of the second target holder that is closer to the substrate holder.

9. The sputtering apparatus according to claim 4, further comprising:
a shield plate provided outside the first target holder and the second target holder, the shield plate having an opening at a position facing the substrate holder,
wherein the auxiliary magnetic field generation unit comprises a first auxiliary magnet and a second auxiliary magnet disposed such that the first auxiliary magnet and the second auxiliary magnet face each other with the opening between the first auxiliary magnet and the second auxiliary magnet.

## Patentansprüche

1. Eine Sputtervorrichtung (10, 20, 30), umfassend:
a) einen ersten Targethalter (111, 311) und einen zweiten Targethalter (112, 312), welche dazu ausgebildet sind, ein erstes Target (T1) bzw. ein zweites Target (T2) zu halten, derart, dass Oberflächen des ersten Targets und des zweiten Targets einander zugewandt sind;
b) einen Substrathalter (16), welcher auf einer Seite eines Plasmaerzeugungsbereichs bereitgestellt ist, der ein Bereich zwischen dem ersten Target und dem zweiten Target ist, welche von dem ersten Targethalter bzw. dem zweiten Targethalter gehalten sind;
c) eine erste Hauptmagnetfeld-Erzeugungseinheit (121, 221, 321) und eine zweite Hauptmagnetfeld-Erzeugungseinheit (122, 222, 322), welche auf einer Seite des ersten Targets gegenüber dem Plasmaerzeugungsbereich bzw. auf einer Seite des zweiten Targets gegenüber dem Plasmaerzeugungsbereich bereitgestellt sind, wobei die erste Hauptmagnetfeld-Erzeugungseinheit und die zweite Hauptmagnetfeld-Erzeugungseinheit dazu ausgebildet sind, ein erstes Hauptmagnetfeld und ein zweites Hauptmagnetfeld an Oberflächen des ersten Targets bzw. des zweiten Targets zu erzeugen, wobei Magnete derart angeordnet sind, dass entgegengesetzte Pole einander zugewandt sind;
d) eine Leistungsversorgung (14), welche dazu ausgebildet ist, durch Anlegen eines vorbestimmten Potenzials an jeden der Targethalter, welche sind der erste Targethalter und der zweite Targethalter, ein elektrisches Feld in dem Plasmagenerierungsbereich zu erzeugen;
e) eine Radiofrequenz-Elektromagnetfeld-Erzeugungseinheit (171), welche dazu ausgebildet ist, ein Radiofrequenz-Elektromagnetfeld in dem Plasmaerzeugungsbereich zu erzeugen, und welche auf einer Seite des Plasmaerzeugungsbereichs bereitgestellt ist, die dem Substrathalter mit dazwischenliegendem Plasmaerzeugungsbereich zugewandt ist;
f) eine Plasmaquellgas-Einführungseinheit (15), welche dazu ausgebildet ist, ein Plasmaquellgas in den Plasmaerzeugungsbereich einzuführen; und **dadurch gekennzeichnet, dass** die Sputtervorrichtung (10, 20, 30) ferner umfasst:
g) eine Hilfsmagnetfeld-Erzeugungseinheit (131, 331), welche dazu ausgebildet ist, an Enden des ersten Targethalters und des zweiten Targethalters auf der Substrathalterseite ein Hilfsmagnetfeld zu erzeugen, welches von einer Seite zu einer anderen Seite des ersten Targethalters und des zweiten Targethalters gerichtet ist, wobei das Hilfsmagnetfeld Kationen und Elektronen in dem Plasmaerzeugungsbereich einschließt,
wobei an Enden des ersten Targethalters und des zweiten Targethalters auf einer Seite der Radiofrequenz-Elektromagnetfeld-Erzeugungseinheit keine Einrichtung zur Erzeugung eines Magnetfeldes vorhanden ist.

2. Die Sputtervorrichtung nach Anspruch 1, wobei der erste Targethalter und der zweite Targethalter das erste Target bzw. das zweite Target derart halten, dass Oberflächen des ersten Targets und des zweiten Targets mit einer Neigung einander zugewandt sind.

3. Die Sputtervorrichtung nach Anspruch 2, wobei eine Distanz zwischen dem ersten Target und dem zweiten Target auf der Seite, welche dem Substrathalter näher liegt, größer ist als auf der Seite, die der Radiofrequenz-Elektromagnetfeld-Erzeugungseinheit näher liegt.

4. Die Sputtervorrichtung nach Anspruch 1, wobei
einer oder beide der Targethalter, welche sind der erste Targethalter und der zweite Targethalter, ein zylindrisches Glied sind, welches ein zylindrisches Target an einer Seitenfläche des zylindrischen Glieds hält und um eine Zylinderachse des zylindrischen Glieds drehbar ist, und
eine der Hauptmagnetfeld-Erzeugungseinheiten, welche sind die erste Hauptmagnetfeld-Erzeugungseinheit und die zweite Hauptmagnetfeld-Erzeugungseinheit, in welcher der korrespondierende Targethalter der zylindrische Targethalter ist, im Inneren des zylindrischen Glieds angeordnet ist.

5. Die Sputtervorrichtung nach einem der Ansprüche 1 bis 4, wobei die Radiofrequenz-Elektromagnetfeld-Erzeugungseinheit eine induktiv gekoppelte Radiofrequenzantenne ist.

6. Die Sputtervorrichtung nach einem der Ansprüche 1 bis 5, wobei eine der Hauptmagnetfeld-Erzeugungseinheiten, welche sind die erste Hauptmagnetfeld-Erzeugungseinheit und die zweite Hauptmagnetfeld-Erzeugungseinheit, einen oder eine Mehrzahl von Permanentmagneten umfasst und ein Pol des einen oder der Mehrzahl von ersten Permanentmagneten der Plasmaerzeugungsraumseite zugewandt ist, und wobei eine andere der Hauptmagnetfeld-Erzeugungseinheiten, welche sind die erste Hauptmagnetfeld-Erzeugungseinheit und die zweite Hauptmagnetfeld-Erzeugungseinheit, einen oder eine Mehrzahl von Permanentmagneten umfasst und ein anderer Pol des einen oder der Mehrzahl von zweiten Permanentmagneten der Plasmaerzeugungsraumseite zugewandt ist.

7. Die Sputtervorrichtung nach einem der Ansprüche 1 bis 6, wobei
eine Größe einer Komponente einer Magnetflussdichte von einem Ende eines der Targethalter, welche sind der erste Targethalter und der zweite Targethalter, auf der Substrathalterseite zu einem Ende eines anderen der Targethalter, welche sind der erste Targethalter und der zweite Targethalter, auf der Substrathalterseite 0,03 T oder mehr beträgt, und
eine Größe einer Komponente einer Magnetflussdichte von einem Ende eines der Targethalter, welche sind der erste Targethalter und der zweite Targethalter, auf einer Seite der Radiofrequenz-Elektromagnetfeld-Erzeugungseinheit in Richtung auf ein Ende eines anderen der Targethalter, welche sind der erste Targethalter und der zweite Targethalter, auf einer Seite der Radiofrequenz-Elektromagnetfeld-Erzeugungseinheit 0,015 T oder weniger beträgt.

8. Die Sputtervorrichtung nach Anspruch 1, wobei die Hilfsmagnetfeld-Erzeugungseinheit umfasst:
einen ersten Hilfsmagneten, welcher an dem Ende des ersten Targethalters bereitgestellt ist, welches dem Substrathalter näher liegt, und
einen zweiten Hilfsmagneten, welcher an dem Ende des zweiten Targethalters bereitgestellt ist, welches dem Substrathalter näher liegt.

9. Die Sputtervorrichtung nach Anspruch 4, ferner umfassend:
eine Abschirmplatte, welche außerhalb des ersten Targethalters und des zweiten Targethalters bereitgestellt ist, wobei die Abschirmplatte eine Öffnung bei einer Position aufweist, welche dem Substrathalter zugewandt ist,
wobei die Hilfsmagnetfeld-Erzeugungseinheit einen ersten Hilfsmagneten und einen zweiten Hilfsmagneten umfasst, welche derart angeordnet sind, dass der erste Hilfsmagnet und der zweite Hilfsmagnet mit zwischen dem ersten Hilfsmagneten und dem zweiten Hilfsmagneten befindlicher Öffnung einander zugewandt sind.

## Revendications

1. Appareil de pulvérisation cathodique (10, 20, 30) comprenant :
a) un premier support de cible (111, 311) et un second support de cible (112, 312) configurés pour maintenir une première cible (T1) et
une seconde cible (T2) respectivement de sorte que les surfaces de la première cible et de la seconde cible se font face ;
b) un support de substrat (16) prévu sur un côté d'une zone de génération de plasma qui est une zone entre la première cible et la seconde cible respectivement maintenues par le premier support de cible et le second support de cible ;
c) une première unité de génération de champ magnétique principal (121, 221, 321) et une seconde unité de génération de champ magnétique principal (122, 222, 322)
respectivement prévues sur un côté de la première cible opposée à la zone de génération de plasma et sur un côté de la seconde cible opposée à la zone de génération de plasma, la première unité de génération de champ magnétique principal et la seconde unité de génération de champ magnétique principal étant configurées pour générer respectivement un premier champ magnétique principal et un second champ magnétique principal sur les surfaces de la première cible et de la seconde cible, dans lequel des aimants sont disposés de sorte que les pôles opposés se font face ;
d) une alimentation électrique (14) configurée pour générer un champ électrique dans la zone de génération de plasma en appliquant un potentiel prédéterminé à chacun du premier support de cible et du second support de cible ;
e) une unité de génération de champ électromagnétique à radiofréquence (171) configurée pour générer un champ électromagnétique à radiofréquence dans la zone de génération de plasma, qui est prévue sur un côté de la zone de génération de plasma faisant face au support de substrat avec la zone de génération de plasma entre eux ;
f) une unité d'introduction de gaz source de plasma (15) configurée pour introduire un gaz source de plasma dans la zone de génération de plasma ; et **caractérisé en ce que** l'appareil de pulvérisation cathodique (10, 20, 30) comprend en outre
g) une unité de génération de champ magnétique auxiliaire (131, 331) configurée pour générer, aux extrémités du premier support de cible et du second support de cible sur le côté du support de substrat, un champ magnétique auxiliaire dirigé d'un côté à un autre côté du premier support de cible et du second support de cible, le champ magnétique auxiliaire confinant les cations et les électrons dans la zone de génération de plasma,
dans lequel des moyens pour générer un champ magnétique n'existent pas aux extrémités du premier support de cible et du second support de cible sur un côté de l'unité de génération de champ électromagnétique à radiofréquence.

2. Appareil de pulvérisation cathodique selon la revendication 1, dans lequel le premier support de cible et le second support de cible maintiennent respectivement la première cible et la seconde cible de sorte que les surfaces de la première cible et de la seconde cible se font face de manière inclinée.

3. Appareil de pulvérisation cathodique selon la revendication 2, dans lequel une distance entre la première cible et la seconde cible est plus grande sur le côté plus proche du support de substrat que sur le côté plus proche de l'unité de génération de champ électromagnétique à radiofréquence.

4. Appareil de pulvérisation cathodique selon la revendication 1, dans lequel
l'un ou les deux du premier support de cible et du second support de cible est un organe cylindrique qui maintient une cible cylindrique sur une surface latérale de l'organe cylindrique et est rotatif autour d'un axe d'un cylindre de l'organe cylindrique, et
l'une de la première unité de génération de champ magnétique principal et de la seconde unité de génération de champ magnétique principal dans laquelle le support de cible correspondant est le support de cible cylindrique est disposée à l'intérieur de l'organe cylindrique.

5. Appareil de pulvérisation cathodique selon l'une quelconque des revendications 1 à 4, dans lequel l'unité de génération de champ électromagnétique à radiofréquence est une antenne à radiofréquence couplée par induction.

6. Appareil de pulvérisation cathodique selon l'une quelconque des revendications 1 à 5, dans lequel l'une de la première unité de génération de champ magnétique principal et de la seconde unité de génération de champ magnétique principal comporte un ou une pluralité d'aimants permanents, et un pôle de l'un ou de la pluralité de premiers aimants permanents fait face au côté d'espace de génération de plasma, et une autre de l'unité de génération de champ magnétique principal et de la seconde unité de génération de champ magnétique principal comporte un ou une pluralité d'aimants permanents, et un autre pôle de l'un ou de la pluralité de seconds aimants permanents fait face au côté d'espace de génération de plasma.

7. Appareil de pulvérisation cathodique selon l'une quelconque des revendications 1 à 6, dans lequel
une magnitude d'une composante d'une densité de flux magnétique d'une extrémité d'un du premier support de cible et du second support de cible sur le côté de support de substrat à une extrémité d'un autre du premier support de cible et du second support de cible sur le côté de support de substrat est de 0,03 T ou plus, et
une magnitude d'une composante d'une densité de flux magnétique d'une extrémité d'un du premier support de cible et du second support de cible sur un côté de l'unité de génération de champ électromagnétique à radiofréquence à une extrémité d'un autre du premier support de cible et du second support de cible sur un côté de l'unité de génération de champ électromagnétique à radiofréquence est de 0,015 T ou moins.

8. Appareil de pulvérisation cathodique selon la revendication 1, dans lequel l'unité de génération de champ magnétique auxiliaire comprend :
un premier aimant auxiliaire prévu à l'extrémité du premier support de cible qui est plus proche du support de substrat, et
un second aimant auxiliaire prévu à l'extrémité du second support de cible qui est plus proche du support de substrat.

9. Appareil de commande de pulvérisation cathodique selon la revendication 4, comprenant en outre :
une plaque de protection prévue à l'extérieur du premier support de cible et du second support de cible, la plaque de protection présentant une ouverture à une position faisant face au support de substrat,
dans lequel l'unité de génération de champ magnétique auxiliaire comprend un premier aimant auxiliaire et un second aimant auxiliaire disposés de sorte que le premier aimant auxiliaire et le second aimant auxiliaire se font face avec l'ouverture entre le premier aimant auxiliaire et le second aimant auxiliaire.
